# EUROPEAN PATENT APPLICATION

(11) **EP 4 250 559 A1**
(43) Date of publication of application: **27.09.2023**
(21) Application number: 23163136.7
(22) Date of filing: 21.03.2023
(51) Int. Cl.: H03F 1/02, H03F 1/22, H03F 3/60

(54) **HIGH POWER BACK-OFF EFFICIENCY ASYMMETRIC-STACKED DIFFERENTIAL QUADRATURE LOAD MODULATION POWER AMPLIFIER**

(30) Priority: 23.03.2022 US 202263322660 P; 25.05.2022 US 202263345470 P; 09.02.2023 US 202318166704
(71) Applicant: Qorvo US, Inc., Greensboro, NC 27409 (US)
(72) Inventor: KOBAYASHI, Kevin Wesley, Torrance, 24015 (US)
(74) Representative: D Young & Co LLP

(57) **Abstract**

A load modulation amplifier (10) is disclosed having a first power amplifier (16) configured to amplify a first portion of a radio frequency signal below a threshold level. A second power amplifier (18) has an N stack of transistor devices configured in a cascode configuration to amplify a second portion of the radio frequency signal that is above the threshold level, wherein N is a counting number that is greater than one.

## Description

### Related Applications

This application claims the benefit of provisional patent application serial number 63/322,660, filed March 23, 2022, and provisional patent application serial number 63/345,470, filed May 25, 2022, the disclosures of which are hereby incorporated herein by reference in their entireties.

### Field of the Disclosure

The present disclosure pertains to amplifiers and in particular to load modulation amplifiers having a carrier amplifier and a peak amplifier coupled in parallel.

### Background

Quadrature combined load modulation power amplifiers (QLMPAs) offer broader bandwidth and load modulation capability compared with a traditional Doherty power amplifier. Asymmetric Doherty amplifiers and QLMPAs typically implement a larger transistor device periphery and associated current for the peaker amplifier to extend the power backed off (PBO) efficiency peak range beyond the traditional 6 dB PBO point to accommodate higher peak-to-average power ratio applications. The larger peaker device periphery comes with lower input and output impedances, resulting in higher impedance transformation matching networks with lower bandwidth and greater peaker amplifier output loading effects.

While asymmetric supply operation has been previously claimed to improve the high efficiency PBO range, the maximum supply operation is constrained by the breakdown voltage of the technology. While different voltage-efficient power devices can be designed and monolithically integrated to improve asymmetric supply load modulation operation, this is not as simple to implement and may require separate optimized epitaxial growth for a vertical heterojunction bipolar transistor device and/or additional reliability qualification for multiple channel designs in a lateral field-effect transistor device technology.

The present disclosure relates to the use of stacked transistors for the peaker amplifiers of a QLMPA to enable greater design trade space for achieving higher power-added efficiency PBO range. The stacked device structure increase provides both higher supply and peak power operation while also providing a higher off-state peaker output impedance for minimizing loading effects on the carrier amplifier, resulting in improved PBO performance and range.

The individual stacked transistor devices may be implemented with multi-gate channel devices with higher voltage operating and/or higher radio frequency impedance characteristics than those of a single transistor to facilitate load modulation action.

The use of the higher voltage stacked peaker operation may be extended to an N-way output coupled load modulation amplifier with increasing voltage-stacked operation for a successive plurality of peaker amplifiers in order to extend the PBO range of high efficiency operation.

### Summary

Particular aspects are set out in the appended independent claims. Various optional embodiments are set out in the dependent claims.

A load modulation amplifier is disclosed having a first power amplifier configured to amplify a first portion of a radio frequency signal below a threshold level. A second power amplifier has an N stack of transistor devices configured in a cascode configuration to amplify a second portion of a radio frequency signal that is above the threshold level, wherein N is a counting number that is greater than one.

Embodiments include a high power back-off efficiency quadrature combined load modulated power amplifier comprised of two asymmetric voltage-operated amplifiers that are output combined by a quadrature four-port coupler. The isolation port of the coupler is typically reflective (open or short) and may be complex impedance but not ideally an absorptive characteristic impedance
(50 Ω) in order to enable enhanced power backed off (PBO) efficiency operation. Enhanced PBO efficiency power range is achieved by increasing the voltage and saturated power operation of the peaker amplifier above the native maximum operating voltage and power capability of the semiconductor device technology by utilizing a stacked transistor in the peaking amplifier. The higher operating voltage and saturated stacked transistor peaking amplifiers facilitate higher 10 dB or greater PBO efficiency enhancement while providing a high output impedance, reducing its load impedance on the carrier amplifier in the peaker's turning off region and reducing efficiency droop at high PBO (lower powers). The disclosure may further be extended to an N-way quadrature combined load modulation amplifier by increasing the device stack of successive power combined peaking amplifiers. The asymmetric supply approach according to the present disclosure preserves bandwidth, which is compromised by the conventional asymmetric approach of increasing the current and associated peaker transistor device size for achieving greater than 6 dB PBO efficiency enhancement practiced in conventional asymmetric Doherty designs.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure and, together with the description, serve to explain the principles of the disclosure.
Figure 1 is a diagram showing the simplest N:1 stack ratio embodiment of an asymmetric stacked differential quadrature combined load modulation power amplifier (QLMPA) according to the present disclosure.
Figure 2 is a diagram showing a general N2:N1 stack ratio embodiment of an asymmetric stacked differential QLMPA according to the present disclosure.
Figure 3 is a diagram showing an illustrative embodiment of an asymmetric 2:1 (2:1 stack peak-to-carrier device ratio) stacked differential QLMPA according to the present disclosure.
Figure 4 is a diagram showing a generalized illustrative embodiment of an asymmetric N:1 (N:1 stack peak-to-carrier device ratio) stacked differential QLMPA according to the present disclosure.
Figure 5 is a diagram showing a three-way embodiment-a 1:2:3 device stack ratio-of an asymmetric stacked differential QLMPA according to the present disclosure.
Figure 6 is a diagram showing a three-way embodiment-a 1:2:M device stack ratio-of an asymmetric stacked differential QLMPA according to the present disclosure.
Figure 7 illustrates the disclosed embodiment reduced to practice: a prototype 40 GHz indium phosphide heterojunction bipolar transistor asymmetric differential QLMPA according to the present disclosure.
Figures 8A and 8B are graphs showing power-added efficiency and gain simulations of asymmetric amplifiers vs. symmetric QLMPAs vs. balanced amplifiers.
Figures 9A and 9B are graphs showing carrier and peaker amplifier load modulation impedance characteristics at the quadrature coupler plane.
Figure 10 is a graph showing the asymmetric-stacked QLMPA over bandwidth.
Figure 11 is a table showing a comparison for asymmetric 2.4V-CE/4.8V-cascode differential QLMPA with respect to non-asymmetric stacked QLMPA designs.
Figures 12A and 12B are graphs showing power-added efficiency and gain simulations of asymmetric amplifiers vs. symmetric QLMPAs vs. balanced amplifiers.
Figures 13A and 13B are graphs showing carrier and peaker amplifier load modulation impedance characteristics at the quadrature coupler plane.
Figure 14 is a graph showing the asymmetric-stacked iso-gain-optimized QLMPA over bandwidth.
Figure 15 is a table showing a comparison for asymmetric 2.4V-CE/4.8V-cascode differential QLMPA iso-gain optimization of an asymmetric-stack versus power backed off/power added efficiency optimization of a symmetric stack.
Figure 16 is a diagram showing how the disclosed load modulation amplifier system may interact with user elements such as wireless communication devices.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

Quadrature combined load modulation power amplifiers (QLMPAs) offer broader bandwidth and load modulation capability compared with a traditional Doherty power amplifier. Asymmetric Doherty amplifiers and QLMPAs typically implement a larger transistor device periphery and associated current for the peaker amplifier to extend the power backed off (PBO) efficiency peak range beyond the traditional 6 dB PBO point to accommodate higher peak-to-average power ratio applications. The larger peaker device periphery comes with lower input and output impedances, resulting in higher impedance transformation matching networks with lower bandwidth and greater peaker amplifier output loading effects.

While asymmetric supply operation has been previously claimed to improve the high efficiency PBO range, the maximum supply operation is constrained by the breakdown voltage of the technology. While different voltage-efficient power devices can be designed and monolithically integrated to improve asymmetric supply load modulation operation, this is not as simple to implement and may require separate optimized epitaxial growth for a vertical heterojunction bipolar transistor (HBT) device and/or additional reliability qualification for multiple channel designs in a lateral field-effect transistor device technology.

The present disclosure relates to the use of stacked transistors for the peaker amplifiers of an asymmetric QLMPA to enable greater design trade space for achieving higher power-added efficiency (PAE) PBO range. The stacked device structure increase provides both higher supply and peak power operation while also providing a higher off-state peaker output impedance for minimizing loading effects on the carrier amplifier, resulting in improved PBO performance and range.

The individual stacked transistor devices may be implemented with multi-gate channel devices with higher voltage operating and/or higher radio frequency (RF) impedance characteristics than those of a single transistor to facilitate load modulation action.

The use of the higher voltage stacked peaker operation may be extended to an N-way output coupled load modulation amplifier with increasing voltage-stacked operation for successive plurality of peaker amplifiers in order to extend the PBO range of high efficiency operation.

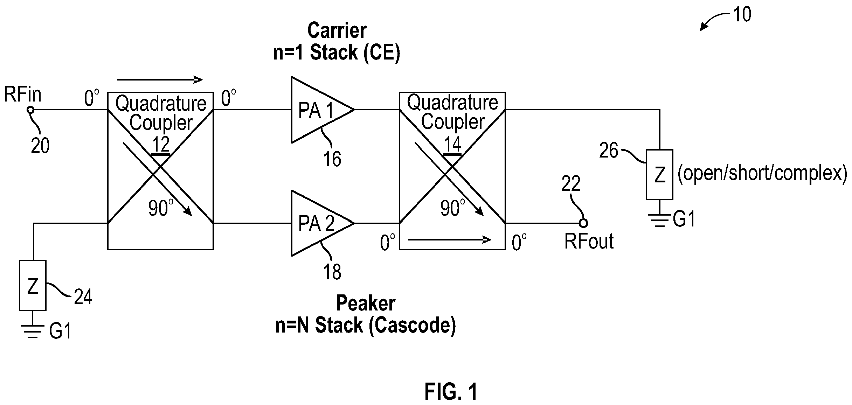

Figure 1 illustrates the asymmetric stacked quadrature load modulation balanced amplifier 10. In example embodiments, both an input quadrature coupler 12 and an output quadrature coupler 14 each have four ports and are of the Lange type having microstrip or strip-line construction with geometric symmetry that ensures quadrature power combining of the output power of a carrier amplifier 16 and a peak amplifier 18. The carrier amplifier 16 and the peak amplifier 18 are coupled in parallel by way of the input quadrature coupler 12 at an input terminal 20 labeled RFin and by way of the output quadrature coupler 14 at an output load terminal 22 labeled RFout.

The input quadrature coupler 12 and the output quadrature coupler 14 both typically have less than 0.25 dB of insertion loss and an approximate octave frequency operating bandwidth. For example, in one embodiment the input quadrature coupler 12 and the output quadrature coupler 14 are both Lange couplers having a minimum frequency of 12 GHz and a maximum frequency of 24 GHz. In another embodiment, the input quadrature coupler 12 and the output quadrature coupler 14 are both Lange couplers having a minimum frequency of 18 GHz and a maximum frequency of 36 GHz. In yet another embodiment, the input quadrature coupler 12 and the output quadrature coupler 14 are both Lange couplers having a minimum frequency of 27 GHz and a maximum frequency of 54 GHz. An input impedance termination network 24 is coupled between an input termination port of the input quadrature coupler 12 and a fixed voltage node G1, which in this example embodiment is ground. An output impedance termination network 26 is coupled between an output termination port of the output quadrature coupler 14 and the fixed voltage node G1. The output coupler termination port may be an open or a short or non-50 ohm complex impedance in order to achieve carrier load modulation operation. The carrier amplifier 16 (PA1) is an n = 1 stack or (common-emitter) transistor configuration and the peaker amplifier 18 (PA2) is an n = N > 1 stack transistor device (common emitter (CE) + (N - 1) common bases (CB)) configuration, wherein n and N are counting numbers.

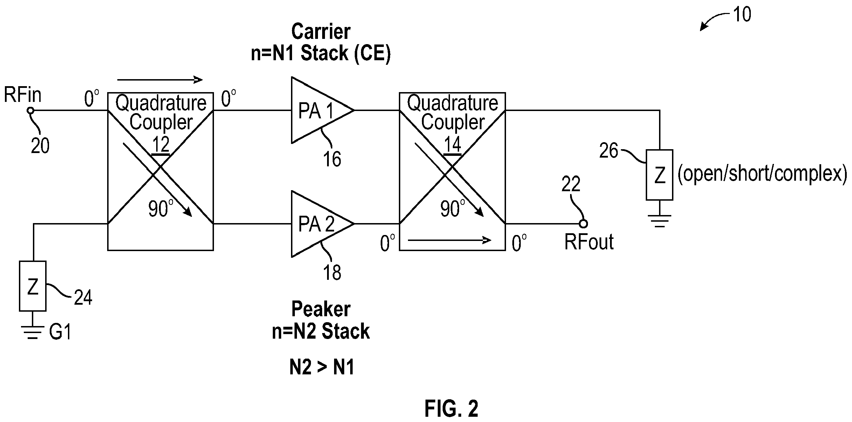

Figure 2 illustrates the asymmetric stacked quadrature load modulation balanced amplifier 10 where the carrier amplifier 16 (PA1) is an n = N1 stack transistor device configuration and the peaker amplifier 18 (PA2) is an n = N2 > N1 stacked transistor device (CE + (N2 - N1) CB) configuration, wherein N1 and N2 are counting numbers. The output coupler termination port may be an open or a short or non-50 ohm complex impedance in order to achieve carrier load modulation operation.

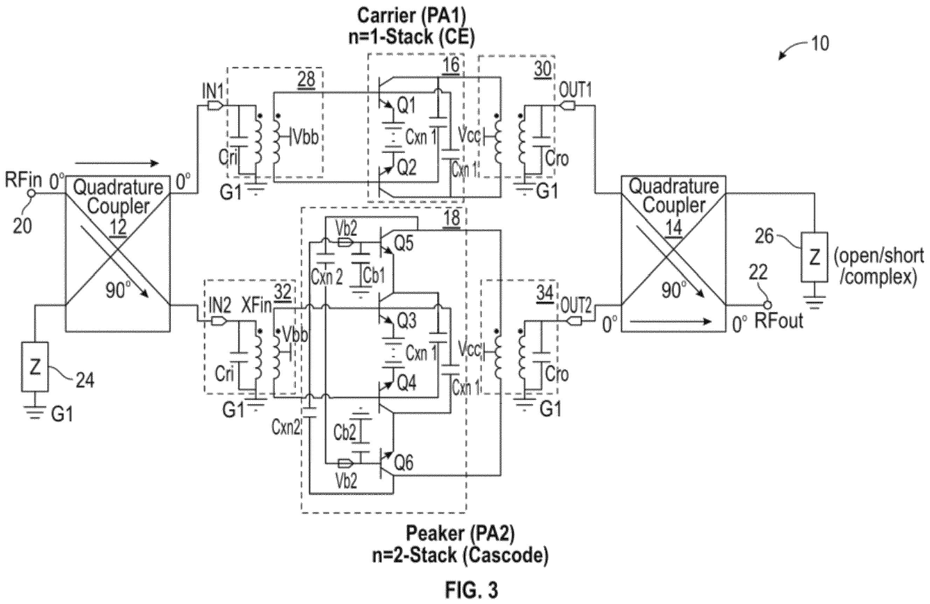

Figure 3 illustrates another embodiment of the asymmetric 2:1 stacked differential quadrature load modulation power amplifier 10. Figure 3 depicts the carrier amplifier 16 (PA1) and the peaker amplifier 18 (PA2) as differential cross-coupled neutralized amplifiers, but it is to be understood that single-ended amplifiers may be employed without departing from the scope of present embodiments having asymmetric N-stack amplifier transistor device configurations. In this example embodiment, the carrier amplifier 16 has a first transistor device Q1 and a second transistor device Q2 that are both in common emitter configurations having emitters that are coupled to the fixed voltage node G1.

The first transistor device Q1 has a base coupled to one end of an output winding of an input transformer 28 and the second transistor Q2 has a base coupled to an opposite end of the output winding of the input transformer 28. Base bias Vbb is provided to the first transistor device Q1 and the second transistor device Q2 through of a tap of the output winding of the input transformer 28. An input winding of the input transformer 28 is coupled between a 0° phase output of the input quadrature 12 and the fixed voltage node G1. A resonant input capacitor Cri is coupled in parallel with the input winding of the input transformer 28.

The first transistor device Q1 has a collector coupled to one end of an input winding of a carrier output transformer 30, and the second transistor Q2 has a collector coupled to an opposite end of the input winding on the carrier output transformer 30. Collector voltage Vcc is provided to the first transistor device Q1 and the second transistor device Q2 through of a tap of the input winding of the carrier output transformer 30. A resonant output capacitor Cro is coupled in parallel with the output winding of the carrier output transformer 30. An output OUT1 of the carrier output transformer 30 is coupled to a 90° input port of the output quadrature coupler 14.

First cross-coupling neutralization capacitors Cxn1, one of which is coupled between the base of the first transistor device Q1 and the collector of the second transistor device Q2, and another coupled from the collector of the first transistor device Q1 to the base of the second transistor device Q2 improve power gain and provides amplitude modulation-phase modulation (AM-PM) compensation.

In the example embodiment of Figure 3, the peaker amplifier 18 has a third transistor device Q3 and a fourth transistor device Q4 that are both in common emitter configurations having emitters that are coupled to the fixed voltage node G1. The third transistor device Q3 has a base coupled to one end of an output winding of a peaker input transformer 32, and the fourth transistor Q4 has a base coupled to an opposite end of the output winding of the peaker input transformer 32. Base bias Vbb is provided to the third transistor device Q3 and the fourth transistor device Q4 through of a tap of the output winding of the peaker input transformer 32. An input winding of the peaker input transformer 32 is coupled between a 90° phase output of the input quadrature 12 and the fixed voltage node G1. A resonant input capacitor Cri is coupled in parallel with the input winding of the peaker input transformer 32.

A fifth transistor device Q5 is coupled into a common-base configuration with a base capacitor Cb1 being coupled between the base of the fifth transistor device Q5 and the fixed voltage node G1. An emitter of the fifth transistor device Q5 is coupled to a collector of the third transistor device Q3. A sixth transistor device Q6 is coupled into a common-base configuration with a base capacitor Cb2 being coupled between the base of the sixth transistor device Q6 and the fixed voltage node G1. An emitter of the sixth transistor device Q6 is coupled to a collector of the fourth transistor device Q4.

The fifth transistor device Q5 has a collector coupled to one end of an input winding of a peaker output transformer 34 and the sixth transistor Q6 has a collector coupled to an opposite end of the input winding on the peaker output transformer 34. Collector voltage Vcc is provided to the fifth transistor device Q5 and the sixth transistor device Q6 through of a tap of the input winding of the output transformer 34. A resonant output capacitor Cro is coupled in parallel with the output winding of the peaker output transformer 34. An output OUT2 of the peaker output transformer 34 is coupled to a 0° input port of the output quadrature coupler 14. Second cross-coupling neutralization capacitors Cxn2, one of which is coupled between the base of the fifth transistor device Q5 and the collector of the sixth transistor device Q6, and another coupled from the collector of the fifth transistor device Q5 to the base of the sixth transistor device Q6 improve power gain and provides amplitude modulation-phase modulation (AM-PM) compensation.

In Figure 3, the carrier amplifier 16 (PA1) is an n = 1 transistor stack having a common-emitter based cross-coupled neutralized differential amplifier configuration, and the peaker amplifier 18 (PA2) is an n = 2 transistor stack with a cascode cross-coupled neutralized differential amplifier configuration. The output termination port of the output quadrature coupler 14 may be an open or a short or non-50 ohm complex impedance in order to achieve carrier amplifier load modulation operation. Stacking the transistors Q3 and Q5 and stacking the transistors Q4 and Q6 of the peaker amplifier 18 (PA2) allows higher supply operation and power of the peaker amplifier 18 (PA2), which helps improve the design trade space for obtaining higher PBO efficiency power range performance. This performance may include iso-gain, flat amplitude modulation-amplitude modulation (AM-AM), or highest PAE versus a PBO power range, or some intermediate performance. Within the N = 2 cascode topology of the peaker amplifier 18 (PA2), there is a base capacitance Cb2 to ground on an upper common-base device of the N-stack transistor devices. The base capacitance Cb2 can be adjusted for optimum reliability and power performance of the stacked transistor device configuration for achieving desired combinations of high PAE, linearity, and reliability. Stacking transistor devices to achieve higher supply and power operation and optimizing the base capacitance Cb2 of the common-base configured fifth transistor device Q5 is desirable in silicon stacked power amplifier design. For example, select ones of the N stack of transistor devices are cascode transistor devices coupled in common base configurations by way of base capacitances coupled to a fixed voltage node, which in this example embodiment is ground. In some embodiments, the base capacitances have non-uniform capacitance values configured to maximize a mean time between failure (i.e., reliability) of the load modulator amplifier 10. In other embodiments, the base capacitances have non-uniform capacitance values configured to maximize output power of the load modulator amplifier 10. In yet other embodiments, the base capacitances have non-uniform capacitance values configured to maximize power-added efficiency of the load modulator amplifier 10. In still other embodiments, the base capacitances have non-uniform capacitance values configured to maximize linear gain of the load modulator amplifier 10.

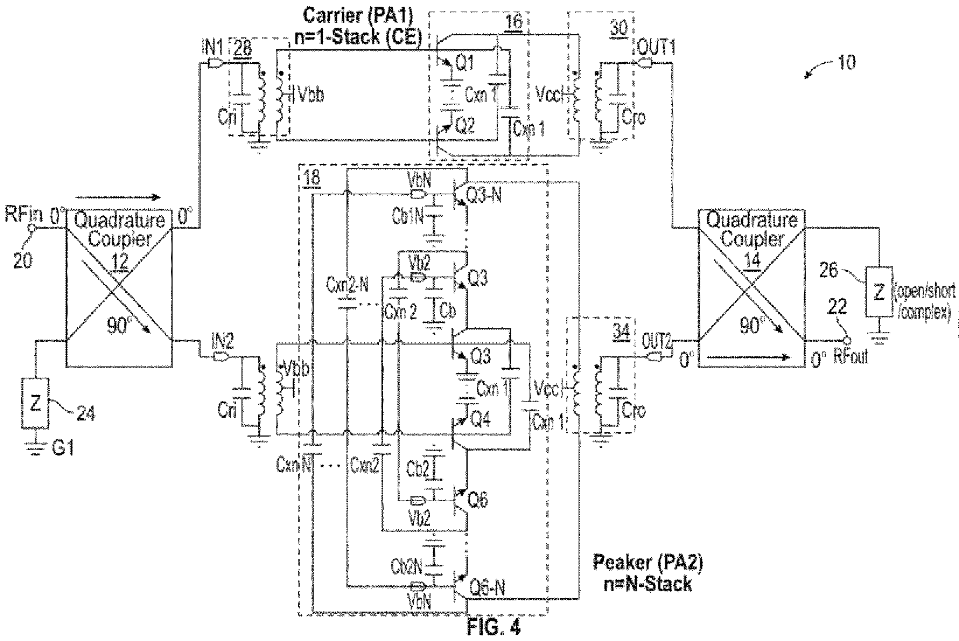

Figure 4 illustrates the asymmetric stacked differential QLMPA 10 where the carrier amplifier (PA1) is an n = 1 stack or common-emitter and the peaker amplifier (PA2) is an n = N transistor stack or a cascode configuration. The output impedance termination network 26 depicted coupled to a coupler termination port of the output quadrature coupler 14 may be an open or a short or non-50 ohm complex impedance in order to achieve carrier load modulation operation.

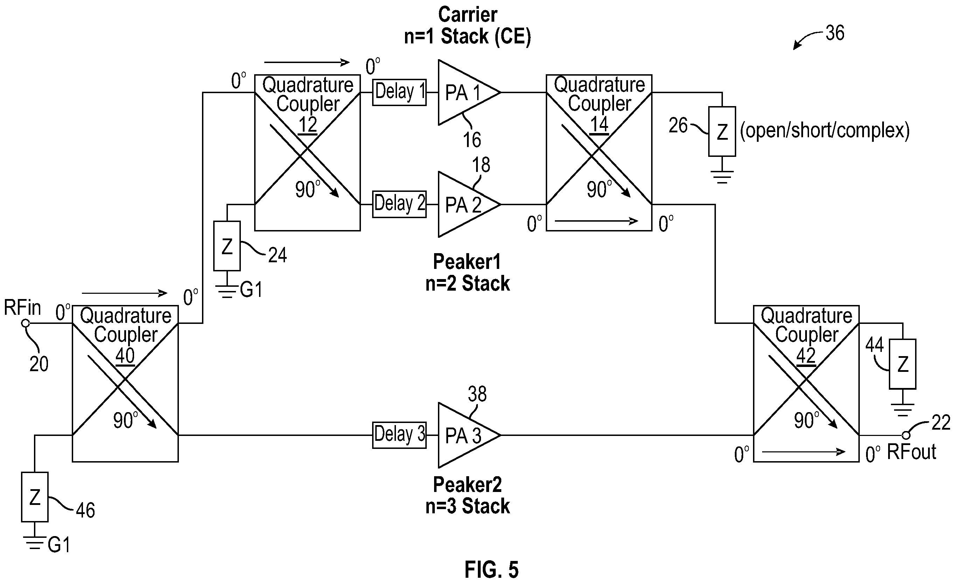

Figure 5 illustrates an extension of the asymmetric stacked QLMPA to a three-way combined asymmetric stacked differential QLMPA 36 that includes the carrier amplifier 16 (PA1), which has an n = 1 transistor stack in a common-emitter configuration; the first peaker amplifier 18 (PA2) with an n = 2 transistor stack in a cascode device configuration; and a second peaker amplifier 38 (PA3) with an n = 3 transistor stack device configuration in order to increase the PBO power range performance in iso-gain, high PAE. The three-way combined asymmetric stacked differential QLMPA 36 includes a second input quadrature coupler 40 and a second output quadrature coupler 42 as shown in Figure 5. Similar to the output termination impedance network 26, a termination impedance 44 coupled to the second output quadrature coupler 42 may be an open or a short or non-50 ohm complex impedance in order to achieve carrier load modulation operation. A second input impedance termination network 46 is coupled to a termination port of the second input quadrature coupler. Delay elements delay 1, delay 2, and delay 3 may be used in line with each of the carrier amplifier 16 (PA1), the first peaker amplifier 18 (PA2), and the second peaker amplifer 38 (PA3) amplifiers, respectively, in order to time align the operation of the three amplifier RF paths. It should be appreciated that three-way combined asymmetric stacked differential QLMPA 36 may be further extended to an N-way combined QLMPA with N power amplifiers configured with a combination of non-uniform stacked transistor devices, (N - 1) output combiner couplers and accompanying non-50 ohm termination loads, and a plurality of delay elements to align the various RF amplifier paths for preferred PBO operation.

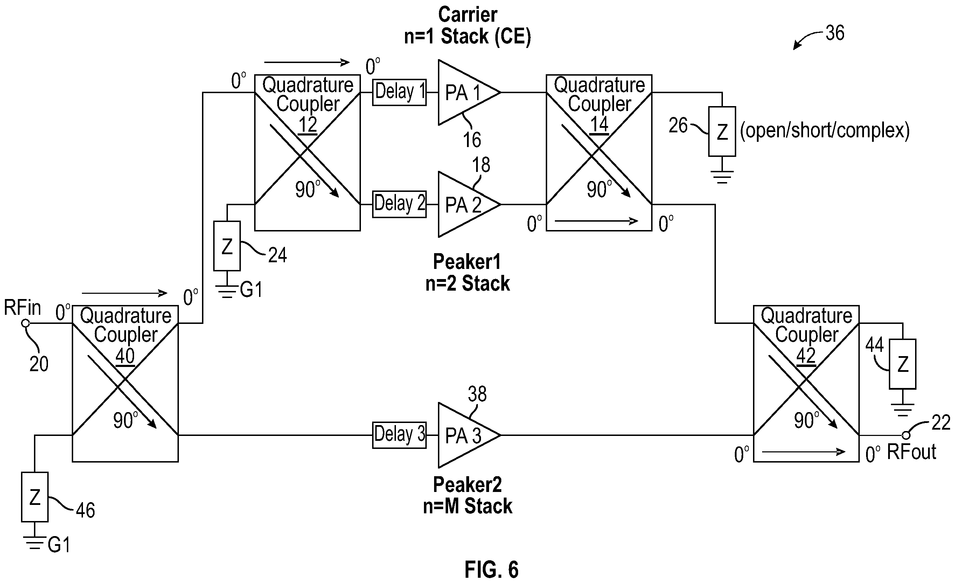

Figure 6 illustrates an extension of the asymmetric stacked QLMPA to the three-way combined asymmetric stacked differential QLMPA 36. However, in this embodiment, the second peaker amplifier 38 (PA3) has an n = M stack device configuration in order to increase the PBO power range performance in iso-gain, high PAE wherein M is a counting number greater than 2. It should be appreciated that this example embodiment of the three-way combined asymmetric-stacked QLMPA 36 may be further extended to an N-way combined QLMPA with N power amplifiers configured with a combination of non-uniform stacked transistor devices, (N - 1) output combiner couplers and accompanying non-50 ohm termination loads, and a plurality of delay elements to align the various RF amplifier paths for preferred PBO operation.

The embodiment according to the present disclosure was reduced to design practice using a 250 nm indium phosphide (InP) HBT technology.

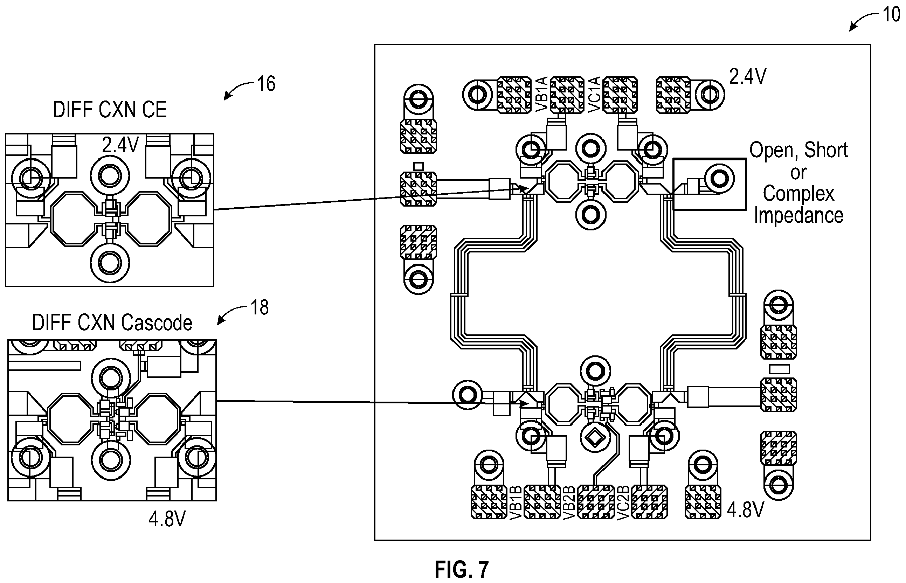

Figure 7 shows the prototype layout of a 40 GHz InP HBT asymmetric differential QLMPA that represents the illustrative embodiment of Figure 3. The carrier amplifier is comprised of a 2.4 V differential single stack (n = 1) common emitter device with cross-coupled neutralization (DIFF CXN CE). The peaker amplifier is comprised of a 4.8 V differential two-stack (n = 2) common-emitter cross-coupled neutralized device cascaded with a differential common-base cross-coupled neutralized device configuration. A single input RF input signal is split by a quadrature Lange coupler the quadrature outputs of which are fed into the 2.4 V single-stacked differential carrier amplifier and 4.8 V two-stacked differential peaker amplifier. The outputs of the differential carrier and peaker amplifiers are combined by an output quadrature Lange coupler. The output termination port of the output quadrature Lange coupler may be laser trimmed for either a short, open, or 50 ohm balanced operation.

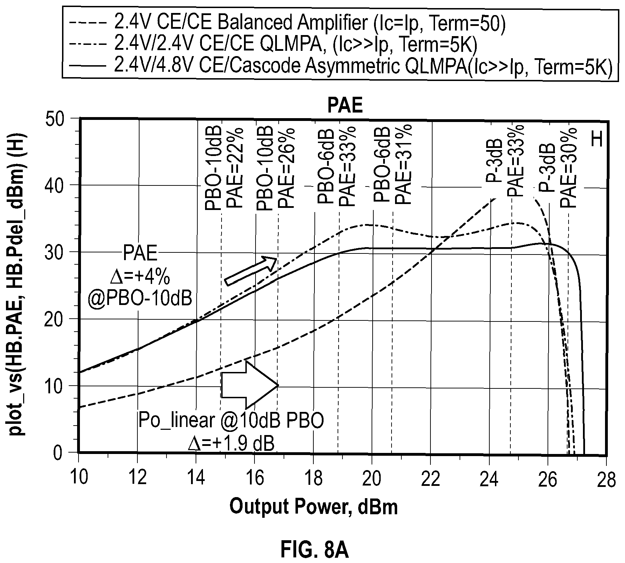

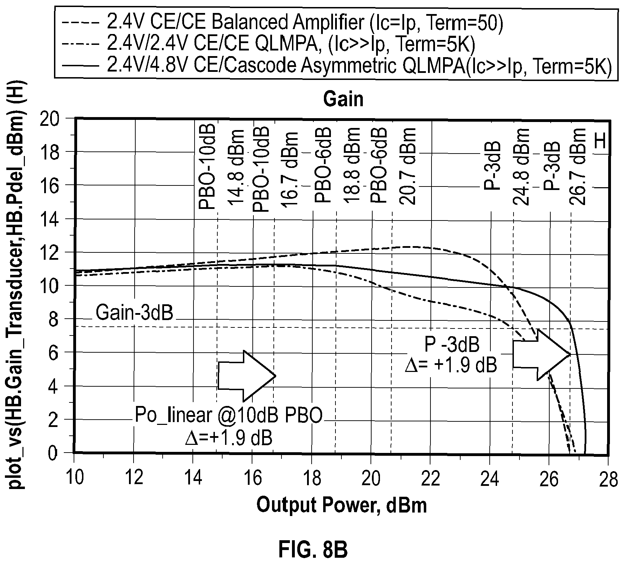

Figures 8A and 8B illustrate the simulated PAE and gain performance of the asymmetric 2:1 stacked QLMPA (solid line) PBO improvements over the symmetric QLMPA (dot-dash line) and traditional balanced amplifier (long-dash line) architectures. To maintain an appropriate comparison for PAE, the low frequency gain and P3dB compression was bias-optimized for each design configuration (balanced, symmetric QLMPA, and asymmetric QLMPA). Linear PBO PAE is defined from the P-3 dB gain compression power, which is defined as 0 dB PBO. This is a good reference as 3 dB may be the maximum that a digital pre-distortion system is able to correct in compression. PAE and Pout are given on the two plots for PBO at 0 dB, 6 dB, and 10 dB for the asymmetric (solid line values) and symmetric-stacked (dot-dash line values) QLMPA for a direct comparison. The balanced class B amplifier is given for reference to illustrate the relative improvements of both the asymmetric stacked and symmetric stacked QLMPAs.

From the gain vs Pout plot, the asymmetric QLMPA achieves a flatter gain response (lower AM-AM) over the symmetric QLMPA and balanced amplifiers. In addition, note that the P-3dB compression point is increased by
1.9 dB over the symmetric-stacked QLMPA. The linear 10 dB PBO power of the asymmetric-stacked QLMPA increased 1.9 dB over the symmetric stacked QLMPA. The associated linear PAE at 10 dB PBO of the asymmetric-stacked QLMPA increased by 4% over the symmetric-stacked QLMPA. This is a significant improvement in both linear 10-dB PBO power and PAE over the symmetric-stacked case.

Note that the differential two-stacked-peaker amplifier design was not LP optimized and the simulated performance is considered conservative for the symmetric design, although the simulated performance is still compelling.

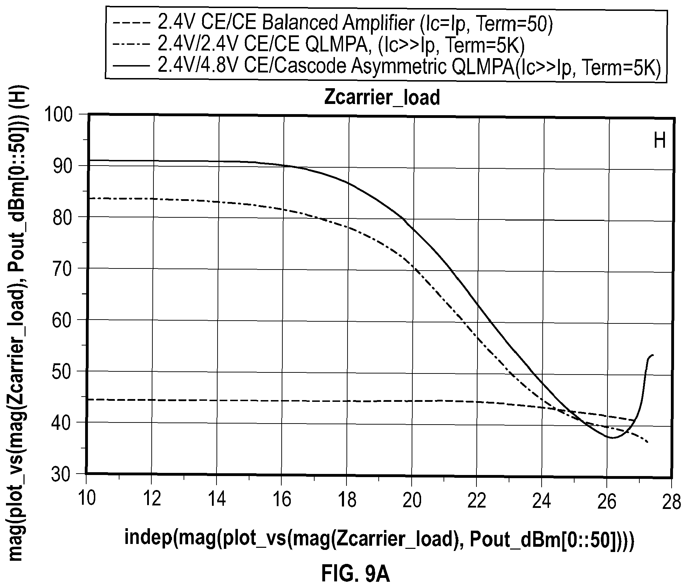

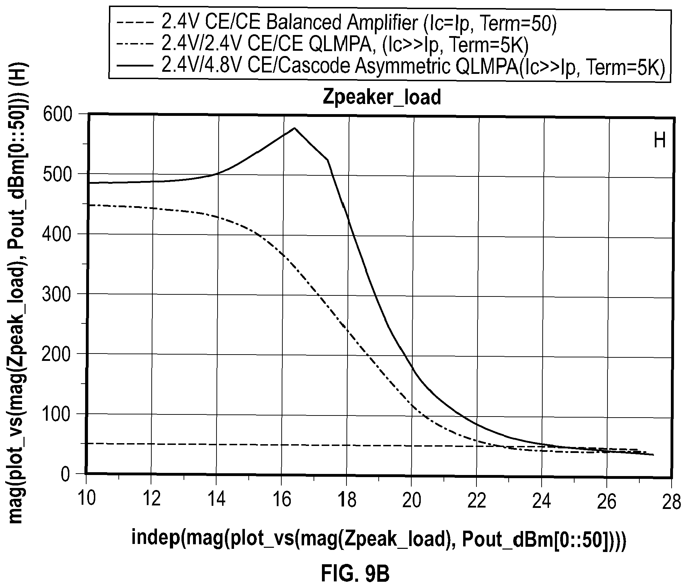

Figures 9A and 9B illustrate the carrier and peaker amplifier load modulation impedance characteristics vs. power, Zcarrier_load, and Zpeaker_load presented to the amplifiers at the quadrature coupler ports for the three different design cases. The carrier and peaker modulation impedances are roughly constant at 45 ohms and 50 ohms, respectively, for the conventional balanced amplifier (long-dash line traces) as expected. The symmetric-stacked QLMPA (dash-dot line trace) illustrates a carrier impedance of 84 ohms at lower power levels and decreases to ~38 ohms at compression, a 2:21 modulation range which is expected. The symmetric-stacked QLMPA peaker load impedance starts out around 450 ohms and converges to ~50 ohms at compression, also expected for the QLMPA, which behaves similarly to a Doherty amplifier. The asymmetric-stacked QLMPA (solid line trace) starts with a carrier impedance of ~91 ohms at low power and reduces to ~38 ohms under compression. The asymmetric-stacked QLMPA exhibits an increased reactive tail impedance, which is beyond the P3dB and can be ignored. The carrier modulation impedance is ~2.4:1. Noteworthy is the higher carrier modulation impedance throughout the range in conjunction with the prolonged and more abrupt impedance transition for the symmetric case. This is believed to be partially explained by the higher output impedance of the peaker two-stacked device configuration, which reduces the mutual dynamic loading on the carrier amplifier. The associated asymmetric-stacked peaker load impedances start at a higher ~480 ohms and increases at mid-power, prolonging a more abrupt decrease in impedance down to 50 ohms as it goes into compression. Both the higher and prolonged carrier and peaker load impedances enable the asymmetric-stacked QLMPA gain flatness to be extended to higher powers as the amplifier goes into compression, as indicated in Figures 8A and 8B. This is believed to be the result of the higher impedance of a stacked-peaker-device compared with a non-stacked device configuration.

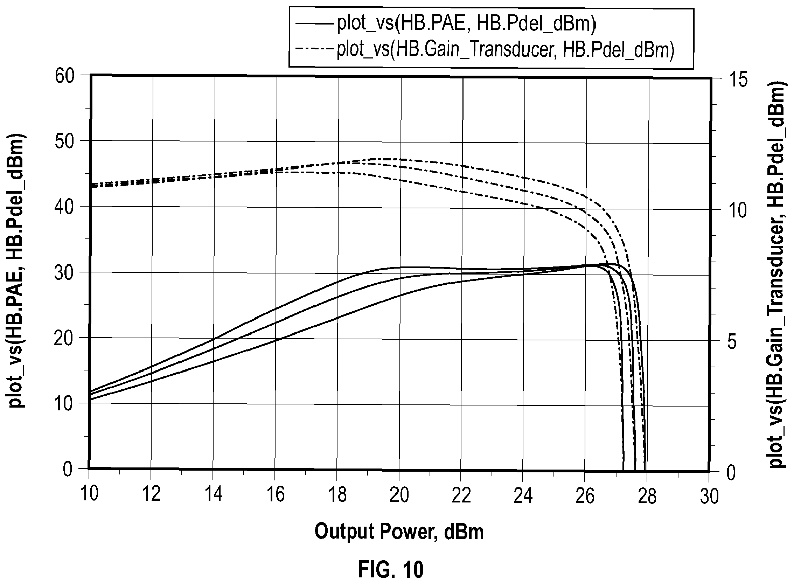

Figure 10 gives the gain and PAE performance of the asymmetric-stacked QLMPA over a 4 GHz bandwidth, a typical bandwidth of a millimeter-wave 5G application. Figure 10 illustrates reasonable performance over bandwidth and is comparable with that of a symmetric-stacked QLMPA. However, note that the carrier impedance load modulation at the coupler plane is translated through an impedance-transformer balun matching network, the bandwidth of which may be narrower than the bandwidth capability of the quadrature coupler combiner. Nonetheless, this demonstrates that effective load modulation operation is achievable using differential power amplifier topologies that employ matching transformer baluns.

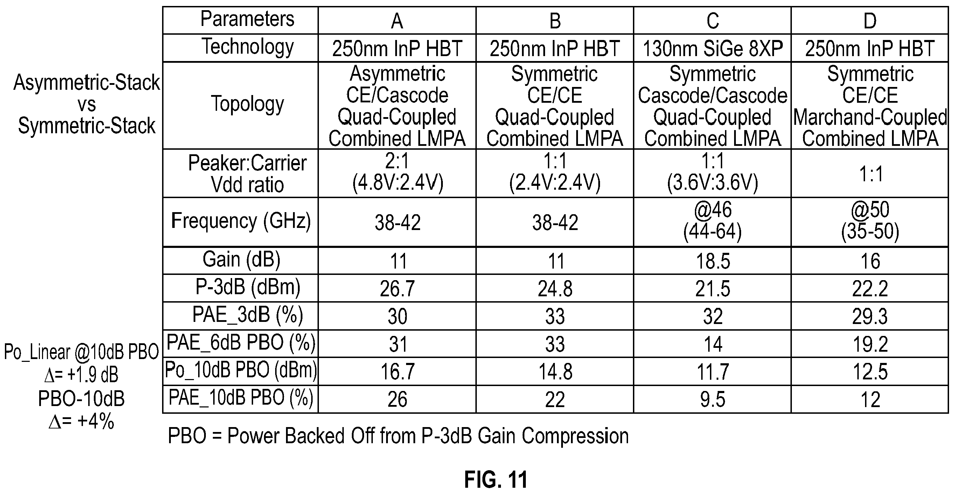

The table in Figure 11 summarizes the best state-of-the-art millimeter-wave quadrature load modulation power amplifiers to date. In particular, the table in Figure 11 compares a 130nm SiGe 8XP symmetric cascode QLMPA (C), a 250nm InP HBT symmetric CE (Marchand based) QLMPA (D), a 250nm InP HBT symmetric CE QLMPA (B), and the 250nm InP HBT asymmetric CE/Cascode QLMPA (A) as disclosed herein. The asymmetric (A) and symmetric (B) QLMPAs outperform the related state-of-the-art devices (C) and (D) in both Pout and PAE at 6 dB and 10 dB PBO, despite (D) using the same device technology. The asymmetric-stacked QLMPA (A) achieves 1.9 dB higher P3dB and linear power at 10 dB PBO, as well as 4% higher PAE at 10 dB PBO, compared with the symmetric-stacked QLMPA (B).

Applications for high PBO PAE load modulated power amplifiers include, but are not limited to, the following:
- 5G/6G basestations
- 5G/6G millimeter-wave phased arrays
- Wireless Fidelity (Wi-Fi): 7 (320 MHz, >10 dB peak-to-average power ratio, <1 % error vector magnitude)
- Mobile phone power amplifiers
- Ku-band satellite communications
- Advanced defense radio systems
- MIDAS-millimeter wave digital arrays

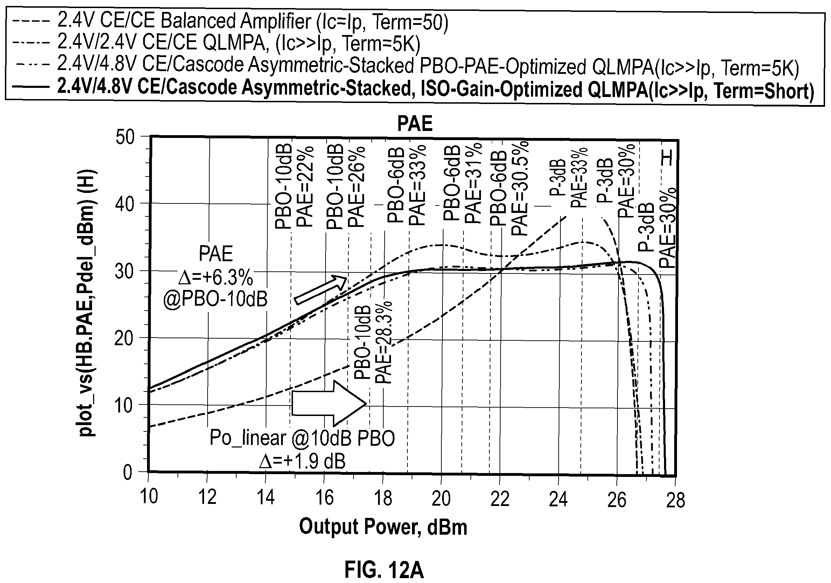

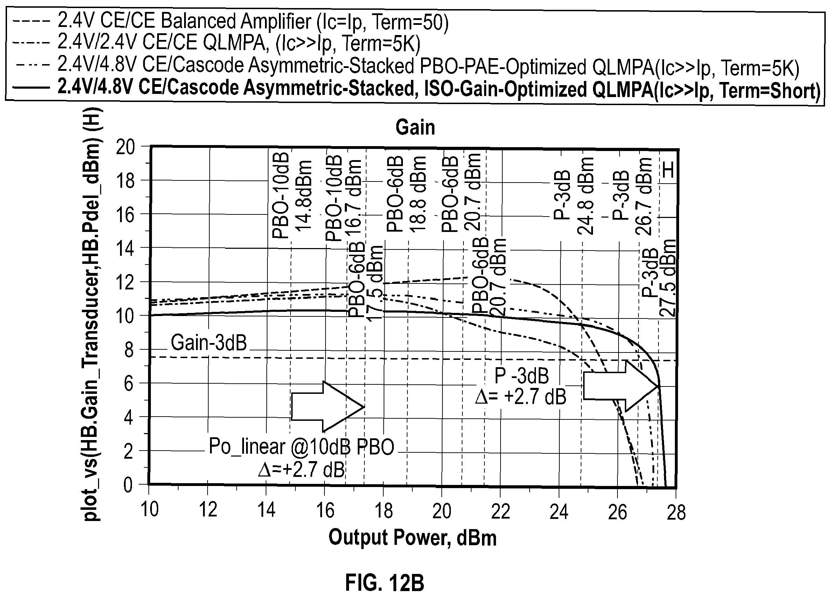

Figures 12A and 12B illustrate the simulated PAE and gain performance of the asymmetric 2:1 stacked iso-gain-optimized QLMPA (solid line) PBO improvements over the asymmetric 2:1 stacked PBO-PAE-optimized QLMPA (double-dot-dash line), the symmetric QLMPA (single-dot-dash line), and traditional balanced amplifier (long-dash line) architectures. To maintain an appropriate comparison for PAE, the low power gain and P3dB compression was bias-optimized for each design configuration (balanced, symmetric QLMPA, and asymmetric QLMPA). Linear PBO PAE is defined from the P-3dB gain compression power, which is defined as 0 dB PBO. This is a good reference as
3 dB may be the maximum that a digital pre-distortion system is able to correct in compression. PAE and Pout are given on the two plots for PBO at 0 dB, 6 dB, and 10 dB for the asymmetric iso-gain-optimized, the asymmetric PBO-PAE-optimized, and the symmetric-stacked QLMPA, in that order, for a direct comparison. The balanced class B amplifier is given for reference to illustrate the relative improvements of both the asymmetric stacked and symmetric stacked QLMPAs. From the gain vs Pout plot of Figure 12B, the asymmetric PBO-PAE-optimized QLMPA (double-dot-dash line) achieves a flatter gain response (lower AM-AM) over the symmetric QLMPA (single-dot-dash line) and balanced (long-dash line) amplifiers. The asymmetric iso-gain-optimized QLMPA (solid line) achieves even flatter gain response than the asymmetric PBO-optimized QLMPA (double-dot-dash line). In addition, note that the PBO-PAE-optimized QLMPA (double-dot-dash line) P-3dB compression point is increased by 1.9 dB over the symmetric-stacked QLMPA (single-dash line) indicating the architecture performance benefit. Moreover, note that the asymmetric-stacked iso-gain-optimized QLMPA (solid line) P-3dB compression point is increased by another 0.8 dB over the asymmetric-stacked PBO-PAE-optimized QLMPA (double-dot-dash line). The linear 10 dB PBO power of the asymmetric-stacked PBO-PAE-optimized QLMPA increased 1.9 dB over symmetric stacked QLMPA, while the linear 10 dB PBO power of the asymmetric-stacked iso-gain-optimized QLMPA increased an additional 0.8 dB over asymmetric-stacked PBO-PAE-optimized QLMPA. The associated linear PAE at 10 dB PBO of the asymmetric-stacked PBO-PAE-optimized QLMPA increased by 4% over the symmetric-stacked QLMPA, while an additional 2.3% increase was obtained from the asymmetric-stacked iso-gain-optimized QLMPA. This is a significant improvement in both linear 10 dB PBO power and PAE for the asymmetric-stacked QLMPA over the symmetric-stacked case.

Note that the differential two-stacked-peaker amplifier design was not LP optimized and the simulated performance is considered conservative for the symmetric design, although the simulated performance is still compelling.

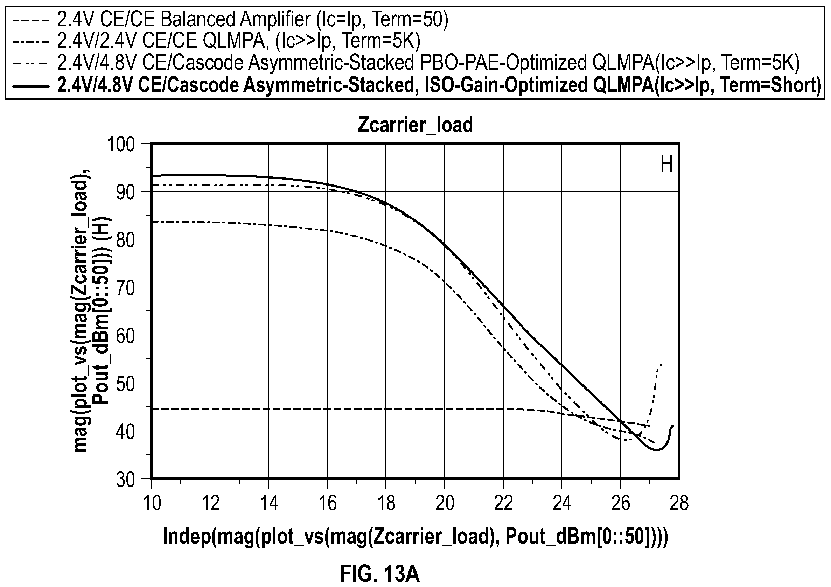

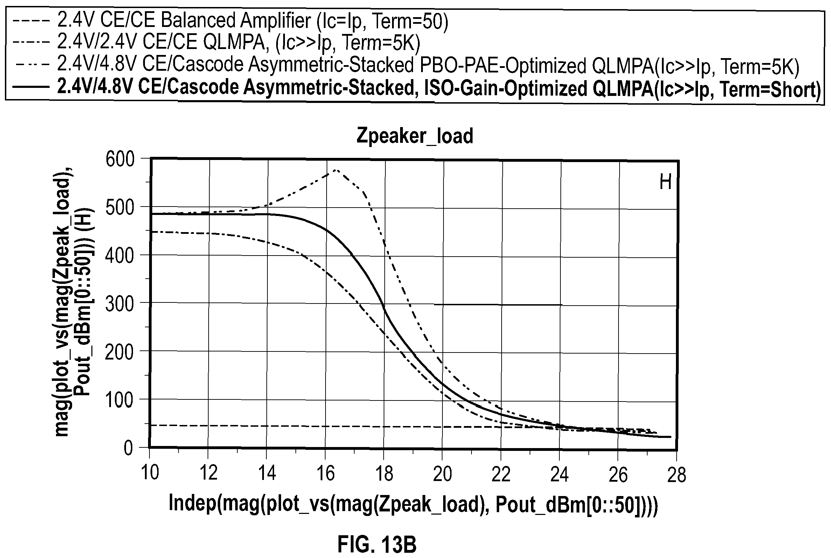

Figures 13A and 13B illustrate the carrier and peaker amplifier load modulation impedance characteristics vs. power, Zcarrier_load, and Zpeaker_load, presented to the amplifiers at the quadrature coupler ports, for the four different design cases. The carrier and peaker modulation impedances are roughly constant at 45 and 50 ohms, respectively, for the conventional balanced amplifier (long-dash line traces) as expected. The symmetric-stacked QLMPA illustrates a carrier impedance of 84 ohms at lower power levels and decreases to ~38 ohms at compression, a 2:21 modulation range, which is expected. The symmetric-stacked QLMPA peaker load impedance starts out around 450 ohms and converges to ~50 ohms at compression, also expected for the QLMPA, which behaves similarly to a Doherty amplifier. The asymmetric-stacked PBO-PAE-optimized QLMPA starts with a carrier impedance of ~91 ohms at low power and reduces to ~38 ohms under compression. The asymmetric-stacked PBO-PAE-optimized QLMPA exhibits an increased reactive tail impedance which is beyond the P3dB and can be ignored. The carrier modulation impedance is ~2.4:1. The asymmetric-stacked iso-gain QLMPA starts with a carrier impedance of ~93 ohms at low power and reduces to ~36 ohms under compression. The asymmetric-stacked iso-gain QLMPA exhibits an increased reactive tail impedance, which is beyond the P3dB and can be ignored. The carrier modulation impedance is ~2.6:1. Note that for both the asymmetric-stacked QLMPA cases, the carrier modulation dynamic impedance is higher throughout the range and exhibits a prolonged and more abrupt impedance transition for the symmetric-stacked QLMPA case. This is believed to be partially explained by the higher output impedance of the peaker two-stacked device configuration compared with using a single-stacked conventional device, which reduces the mutual dynamic loading effect on the carrier amplifier. The associated asymmetric-stacked peaker load impedance starts at a higher ~500 ohms and increases at mid-power, prolonging a more abrupt decrease in impedance down to 50 ohms as it goes into compression. The higher and prolonged carrier and peaker load impedance enables the gain flatness of the asymmetric-stacked QLMPAs to be extended to higher powers as it goes into compression, as indicated in Figures 12A and 12B. This is believed to be the result of the higher impedance of a stacked-peaker-device compared with a non-stacked device configuration.

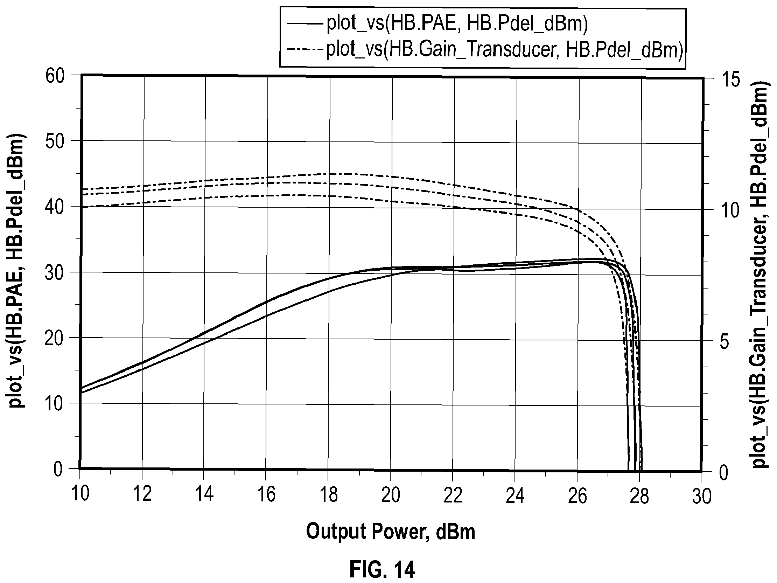

Figure 14 gives the gain and PAE performance of the asymmetric-stacked iso-gain-optimized QLMPA over a 4 GHz bandwidth, a typical bandwidth of a millimeter-wave 5G application. Figure 14 illustrates desired performance over bandwidth and is comparable with that of a symmetric-stacked QLMPA. However, note that the carrier impedance load modulation at the coupler plane is translated through impedance-transformer balun matching networks the bandwidth of which may be narrower than the bandwidth capability of the quadrature coupler combiner. Nonetheless, this demonstrates that effective load modulation operation is achievable using differential power amplifier topologies that employ matching transformer baluns.

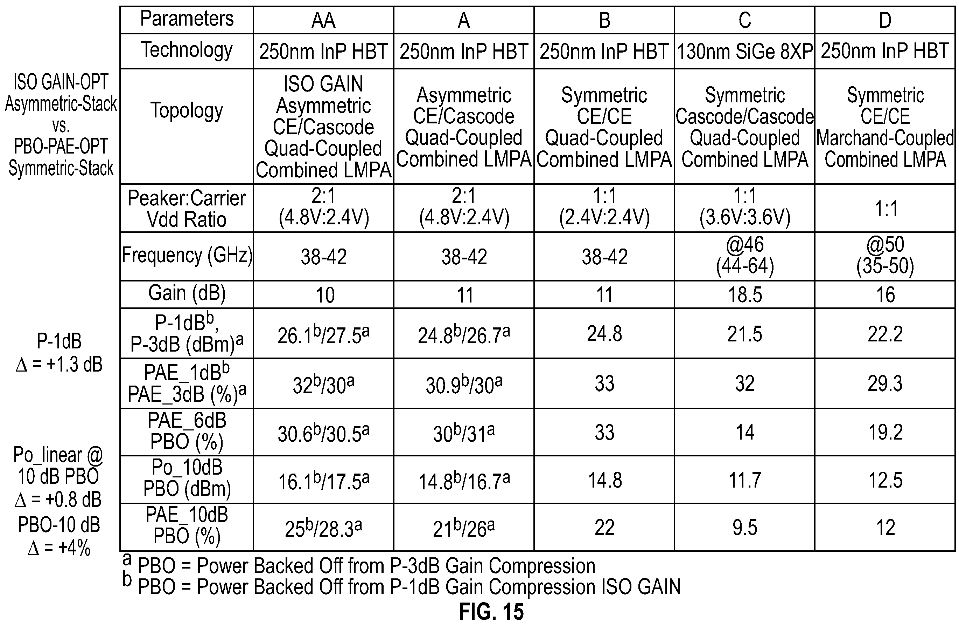

Figure 15 is a table showing a comparison for asymmetric 2.4V-CE/4.8V-cascode differential QLMPA iso-gain optimization of an asymmetric stack versus power backed off/power-added efficiency optimization of a symmetric stack. In particular, the table in Figure 15 compares a 130nm SiGe 8XP symmetric cascode QLMPA (C), a 250nm InP HBT symmetric CE (Marchand based) QLMPA (D), a 250nm InP HBT symmetric CE QLMPA (B), the 250nm InP HBT asymmetric CE/Cascode QLMPA (A) and the iso-gain 250nm InP HBT asymmetric CE/Cascode QLMPA (AA) as disclosed herein. The iso-gain asymmetric (AA), the asymmetric (A) and symmetric (B) QLMPAs outperform the related state-of-the-art devices (C) and (D) in both Pout and PAE at 10 dB PBO, despite (D) using the same device technology. The asymmetric-stacked QLMPA (A) achieves 0.8 dB higher P3dB and linear power at 10 dB PBO, as well as 4% higher PAE at 10 dB PBO, compared with the symmetric-stacked QLMPA (B). Moreover, at P-1 dB the present QLMPAs achieve 1.3 dB over the related state-of-the-art devices (C) and (D). For example, there is a high potential for adjusting the Vcc_peak up to the N*Vce_p(maximum safe operating quiescent voltage) and Vcc_carrier up to M*Vce_c(maximum safe operating quiescent voltage) where typically M = 1. The adjustment in either or both Vcc_peak and Vcc_carrier optimizes (a) PAE, (b) linearity, (c) iso-gain characteristics, (d) signal modulation and bandwidth, and (e) dynamic changing peak-to-average power ratio.

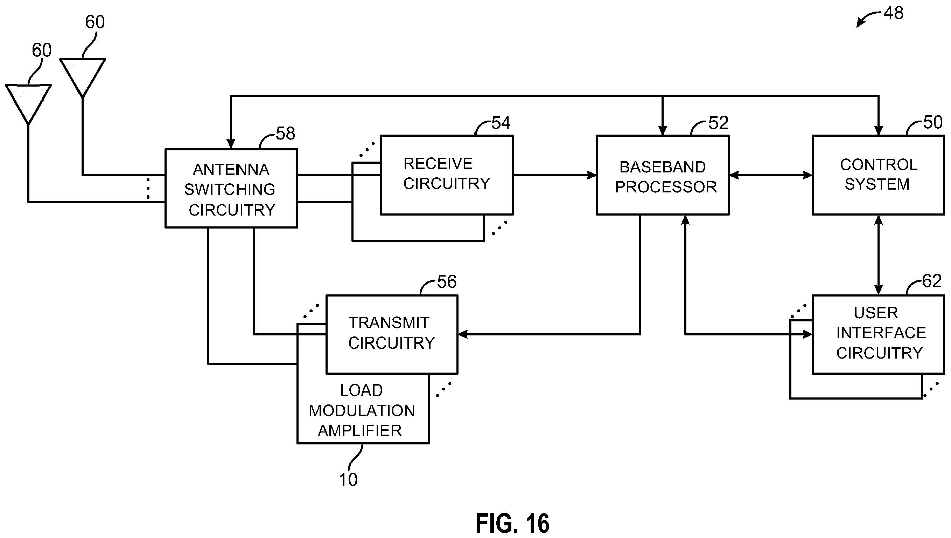

With reference to Figure 16, the concepts described above may be implemented in various types of wireless communication devices or user elements 48, such as mobile terminals, smart watches, tablets, computers, navigation devices, access points, and the like that support wireless communications, such as cellular, wireless local area network (WLAN), Bluetooth, and near-field communications. The user elements 48 will generally include a control system 50, a baseband processor 52, receive circuitry 54, transmit circuitry 56 that includes the load modulation amplifier 10, antenna switching circuitry 58, multiple antennas 60, and user interface circuitry 62. The receive circuitry 54 receives radio frequency signals via the antennas 60 and through the antenna switching circuitry 58 from one or more basestations. A low-noise amplifier and a filter cooperate to amplify and remove broadband interference from the received signal for processing. Downconversion and digitization circuitry (not shown) will then downconvert the filtered, received signal to an intermediate or baseband frequency signal, which is then digitized into one or more digital streams.

The baseband processor 52 processes the digitized received signal to extract the information or data bits conveyed in the received signal. This processing typically comprises demodulation, decoding, and error correction operations. The baseband processor 52 is generally implemented in one or more digital signal processors and application-specific integrated circuits.

For transmission, the baseband processor 52 receives digitized data, which may represent voice, data, or control information, from the control system 50, which it encodes for transmission. The encoded data is output to the transmit circuitry 54, where it is used by a modulator to modulate a carrier signal that is at a desired transmit frequency or frequencies. A power amplifier will amplify the modulated carrier signal to a level appropriate for transmission and deliver the modulated carrier signal through the antenna switching circuitry 58 to the antennas 60. The antennas 60 and the replicated transmit circuitry 56 and receive circuitry 54 may provide spatial diversity. Modulation and processing details will be understood by those skilled in the art.

Therefore, from one perspective, there has been described a load modulation amplifier having a first power amplifier configured to amplify a first portion of a radio frequency signal below a threshold level. A second power amplifier has an N stack of transistor devices configured in a cascode configuration to amplify a second portion of the radio frequency signal that is above the threshold level, wherein N is a counting number that is greater than one.

Further examples are set out in the following numbered clauses:
Clause 1. A load modulation amplifier comprising: a first power amplifier (PA) configured to amplify a first portion of a radio frequency (RF) signal below a threshold level; and a second PA comprising an N stack of transistor devices configured in a cascode configuration to amplify a second portion of an RF signal that is above the threshold level, wherein N is a counting number that is greater than one.
Clause 2. The load modulation amplifier of clause 1 wherein the first PA comprises transistor devices that are not stacked.
Clause 3. The load modulation amplifier of clause 2 wherein the transistors devices that are not stacked are in common emitter configurations.
Clause 4. The load modulation amplifier of clause 1, 2 or 3 further comprising an output quadrature coupler configured to combine portions of an amplified version of the RF signal.
Clause 5. The load modulation amplifier of clause 4 wherein the output quadrature coupler is terminated by a reflective short.
Clause 6. The load modulation amplifier of clause 4 wherein the output quadrature coupler is terminated by a low complex impedance that is less than 50 ohms.
Clause 7. The load modulation amplifier of clause 4 wherein the output quadrature coupler is terminated by a reflective open.
Clause 8. The load modulation amplifier of clause 4 wherein the output quadrature coupler is terminated by a high complex impedance that is greater than 50 ohms.
Clause 9. The load modulation amplifier of clause 4 wherein the output quadrature coupler is terminated by substantially 50 ohms.
Clause 10. The load modulation amplifier of any preceding clause wherein select ones of the N stack of transistor devices are cascode transistor devices coupled in common base configurations by way of base capacitances coupled to a fixed voltage node.
Clause 11. The load modulation amplifier of clause 10 wherein the fixed voltage node is ground.
Clause 12. The load modulation amplifier of clause 10 or 11 wherein the base capacitances have non-uniform capacitance values configured to maximize gain of the load modulation amplifier.
Clause 13. The load modulation amplifier of clause 10 or 11 wherein the base capacitances have non-uniform capacitance values configured to maximize a mean time between failure rate of the load modulation amplifier.
Clause 14. The load modulation amplifier of clause 10 or 11 wherein the base capacitances have non-uniform capacitance values configured to maximize output power of the load modulation amplifier.
Clause 15. The load modulation amplifier of clause 10 or 11 wherein the base capacitances have non-uniform capacitance values configured to maximize power-added efficiency of the load modulation amplifier.
Clause 16. The load modulation amplifier of clause 10 or 11 wherein the base capacitances have non-uniform capacitance values configured to maximize linear gain of the load modulation amplifier.
Clause 17. The load modulation amplifier of any preceding clause wherein the first PA and the second PA are coupled in parallel.
Clause 18. The load modulation amplifier of clause 17 wherein the first PA is a carrier amplifier and the second PA is a peaker amplifier configured to operate as a Doherty amplifier.
Clause 19. The load modulation amplifier of any preceding clause wherein the first PA and the second PA are both configured as differential amplifiers.
Clause 20. The load modulation amplifier of any preceding clause further comprising a third PA coupled in parallel with the first PA and the second PA in a 3-way quadrature coupler configuration.
Clause 21. The load modulation amplifier of clause 20 wherein the third PA comprises an M stack of transistor devices configured in a cascode configuration to amplify a portion of the RF signal that is above the threshold level, wherein M is a counting number that is greater than one.
Clause 22. The load modulation amplifier of clause 20 wherein the third PA is configured as a second peaker amplifier.
Clause 23. The load modulation amplifier of any preceding clause wherein the N stack of transistor devices is realized by a dual-gate field-effect transistor device.
Clause 24. The load modulation amplifier of any preceding clause wherein the N stack of transistor devices is realized by a field-effect transistor device having a first field plate and a second field plate, wherein the second field plate is between a gate and a drain.
Clause 25. A wireless communication device comprising: a baseband processor; transmit circuitry configured to receive encoded data from the baseband processor and to modulate a carrier signal with the encoded data, wherein the transmit circuitry comprises: a first power amplifier (PA) configured to amplify a first portion of a radio frequency (RF) signal below a threshold level; and a second PA comprising an N stack of transistor devices configured in a cascode configuration to amplify a second portion of the RF signal that is above the threshold level, wherein N is a counting number that is greater than one.
Clause 26. The wireless communication device of clause 25 wherein the first PA comprises transistor devices that are not stacked.
Clause 27. The wireless communication device of clause 26 wherein the transistors devices that are not stacked are in common emitter configurations.
Clause 28. The wireless communication device of clause 25, 26 or 27 further comprising an output quadrature coupler configured to combine portions of an amplified version of the RF signal.
Clause 29. The wireless communication device of clause 28 wherein the output quadrature coupler is terminated by a reflective short.
Clause 30. The wireless communication device of clause 28 wherein the output quadrature coupler is terminated by a low complex impedance that is less than 50 ohms.
Clause 31. The wireless communication device of clause 28 wherein the output quadrature coupler is terminated by a reflective open.
Clause 32. The wireless communication device of clause 28 wherein the output quadrature coupler is terminated by a high complex impedance that is greater than 50 ohms.
Clause 33. The wireless communication device of clause 28 wherein the output quadrature coupler is terminated by substantially 50 ohms.
Clause 34. The wireless communication device of any of clauses 25 to 33wherein select ones of the N stack of transistor devices are cascode transistor devices coupled in common base configurations by way of base capacitances coupled to a fixed voltage node.
Clause 35. A method of operating a load modulation amplifier having a first power amplifier (PA) and a second PA having an N stack of transistor devices configured in a cascode configuration, wherein N is a counting number, the method comprising: amplifying a first portion of a radio frequency (RF) signal below a threshold level; and amplifying by way of the N stack of transistor devices a second portion of the RF signal that is above the threshold level.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

## Claims

1. A load modulation amplifier comprising:
• a first power amplifier (PA) configured to amplify a first portion of a radio frequency (RF) signal below a threshold level; and
• a second PA comprising an N stack of transistor devices configured in a cascode configuration to amplify a second portion of an RF signal that is above the threshold level, wherein N is a counting number that is greater than one.

2. The load modulation amplifier of claim 1 wherein the first PA comprises transistor devices that are not stacked.

3. The load modulation amplifier of claim 2 wherein the transistors devices that are not stacked are in common emitter configurations.

4. The load modulation amplifier of claim 1, 2 or 3 further comprising an output quadrature coupler configured to combine portions of an amplified version of the RF signal.

5. The load modulation amplifier of claim 4 wherein the output quadrature coupler is terminated by one or more selected from the group comprising: a reflective short; a low complex impedance that is less than 50 ohms; a reflective open; a high complex impedance that is greater than 50 ohms; and substantially 50 ohms.

6. The load modulation amplifier of any preceding claim wherein select ones of the N stack of transistor devices are cascode transistor devices coupled in common base configurations by way of base capacitances coupled to a fixed voltage node, for example wherein the fixed voltage node is ground.

7. The load modulation amplifier of claim 6 wherein the base capacitances have non-uniform capacitance values configured to maximize one or more selected from the group comprising: gain of the load modulation amplifier; a mean time between failure rate of the load modulation amplifier; output power of the load modulation amplifier; power-added efficiency of the load modulation amplifier; and linear gain of the load modulation amplifier.

8. The load modulation amplifier of any preceding claim wherein the first PA and the second PA are coupled in parallel.

9. The load modulation amplifier of claim 9 wherein the first PA is a carrier amplifier and the second PA is a peaker amplifier configured to operate as a Doherty amplifier.

10. The load modulation amplifier of any preceding claim wherein the first PA and the second PA are both configured as differential amplifiers.

11. The load modulation amplifier of any preceding claim further comprising a third PA coupled in parallel with the first PA and the second PA in a 3-way quadrature coupler configuration, for example wherein: the third PA comprises an M stack of transistor devices configured in a cascode configuration to amplify a portion of the RF signal that is above the threshold level, wherein M is a counting number that is greater than one; and/or the third PA is configured as a second peaker amplifier.

12. The load modulation amplifier of any preceding claim wherein the N stack of transistor devices is realized by a dual-gate field-effect transistor device.

13. The load modulation amplifier of any preceding claim wherein the N stack of transistor devices is realized by a field-effect transistor device having a first field plate and a second field plate, wherein the second field plate is between a gate and a drain.

14. A wireless communication device comprising:
• a baseband processor;
• transmit circuitry configured to receive encoded data from the baseband processor and to modulate a carrier signal with the encoded data, wherein the transmit circuitry comprises:
• a load modulation amplifier according to any preceding claim.

15. A method of operating a load modulation amplifier having a first power amplifier (PA) and a second PA having an N stack of transistor devices configured in a cascode configuration, wherein N is a counting number, the method comprising:
• amplifying a first portion of a radio frequency (RF) signal below a threshold level; and
• amplifying by way of the N stack of transistor devices a second portion of the RF signal that is above the threshold level.
